# EUROPÄISCHE PATENTSCHRIFT

(11) **EP 2 088 842 B1**
(45) Veröffentlichungstag und Bekanntmachung des Hinweises auf die Patenterteilung: **01.03.2017**
(21) Anmeldenummer: 09150832.5
(22) Anmeldetag: 19.01.2009
(51) Int. Cl.: H05K 7/14, H01R 9/26, H05K 3/00

(54) **Elektronikgehäuse mit einer Leiterplatte und Verfahren zur Herstellung eines Elektronikgehäuses**
Electronics casing with a circuit board and method for producing an electronics casing
Boîtier électronique doté d'une plaquette de circuits et procédé de fabrication d'un boîtier électronique

(30) Priorität: 11.02.2008 DE 102008008716
(43) Veröffentlichungstag der Anmeldung: 12.08.2009
(73) Patentinhaber: Weidmüller Interface GmbH & Co. KG, 32758 Detmold (DE)
(72) Erfinder: Heggemann, Christian, 32758 Detmold (DE); Oesterhaus, Jens, 32760 Detmold (DE); Bönsch, Matthias, 33659 Bielefeld (DE); Niggemann, Matthias, 32694 Dörentrup (DE); Lenschen, Michael, 32756 Detmold (DE); Fehling, Stephan, 32791 Lage (DE); Diekmann, Torsten, 33618 Leopoldshöhe (DE)
(74) Vertreter: Dantz, Jan Henning

(56) Entgegenhaltungen:
- DE-A1-102006 023 660
- DE-U1- 20 120 690
- DE-U1- 29 606 759
- US-A- 5 277 596

## Beschreibung

Die Erfindung betrifft ein Elektronikgehäuse mit einem oder mehreren Leiteranschlüssen für elektrische Leiter und ein Verfahren zur Herstellung eines Elektronikgehäuses.

Einen gattungsgemäßen Stand der Technik zeigt die DE 201 20 690 U1. Es ist seit langem bekannt, direkt auf einer Leiterplatte Leiteranschlüsse zum Anschluss elektrischer Leiter zu löten oder beispielsweise in einem automatischen Lötverfahren eine Stiftleiste mit einem Gehäuse zum Anschluss einer korrespondierenden Buchsenleiste auf eine Leiterplatte zu löten und diese Leiterplatte dann in ein übergeordnetes Leiteranschlussgehäuse - nachfolgend Elektronikgehäuse genannt - einzubauen. Damit baut die Anordnung aber nicht sonderlich schmal, da sich die Höhe der Leiterplatte und die Höhe der Anschlüsse für die Leiter addieren.

Die Erfindung hat die Aufgabe, dieses Problem mit einfachen Mitteln zu beheben.

Die Erfindung löst diese Aufgabe durch den Gegenstand des Anspruchs 1. Sie schafft ferner das Verfahren des Anspruchs 16.

Derart ist auf einfache Weise die Montage eines besonders schmal bauenden Elektronikgehäuses mit einer Leiterplatte, vorzugsweise in anreihbarer Ausgestaltung, realisierbar, da die Leiteranschlüsse mit den Leiteranschlussgehäusen nicht auf sondern außerhalb des Umfangsrandes der Leiterplatte neben der Leiterplatte angeordnet werden und sich zumindest die Leiteranschlussgehäuse vorzugsweise bis in die Ebene der Leiterplatte hinein erstrecken.

Besonders bevorzugt erstrecken sich dabei die Leiteranschlussgehäuse bis in die Ebene der Leiterplatte hinein.

Es ist vorteilhaft, dass die Leiteranschlussgehäuse jedenfalls abschnittsweise selbst einen Teil des Elektronikgehäuses ausbilden, da dies zu einer nochmals schmaleren Bauart beiträgt.

Mit dem erfindungsgemäßen Verfahren kann in einfacher Weise direkt beim Lötvorgang ein Teil des Elektronikgehäuses selbst mit an der Leiterplatte angeordnet werden, so dass die Leiteranschlüsse bei der eigentlichen weiteren Montage des Elektronikgehäuses gut geschützt liegen.

Vorteilhafte Ausgestaltungen der Erfindung sind in den Unteransprüchen angegeben.

Nachfolgend wird die Erfindung unter Bezug auf die Zeichnung anhand von Ausführungsbeispielen näher beschrieben. Es zeigt:
- Fig. 1: eine perspektivische Ansicht eines Elektronikgehäuses;
- Fig. 2: eine Sprengansicht des Elektronikgehäuses aus Fig. 1; und
- Fig. 3 bis 6: ein Verfahren zur Herstellung einer Leiterplatte mit Leiteranschlüssen in vier aufeinanderfolgenden Schritten.

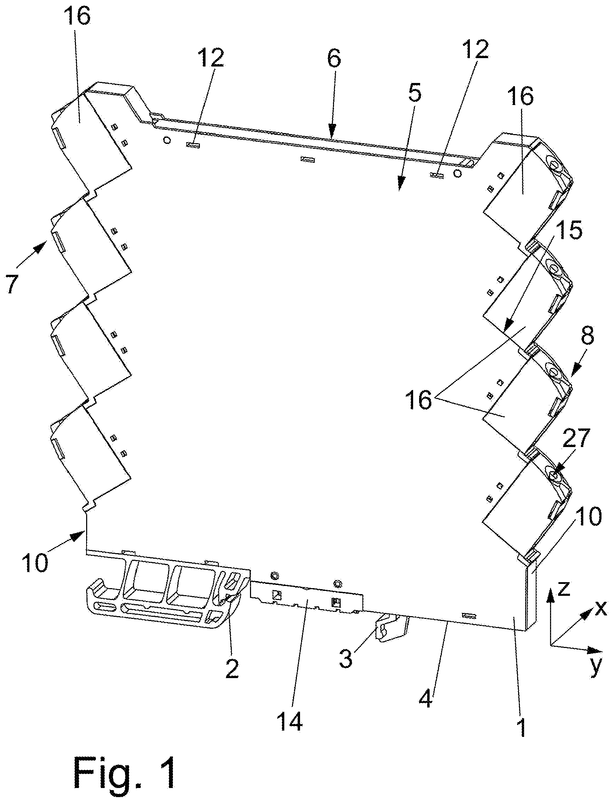

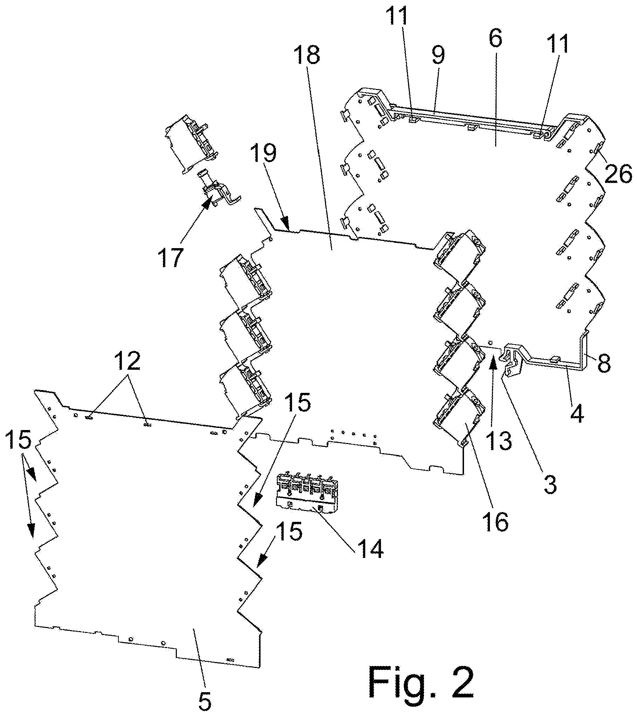

Fig. 1 und 2 zeigen ein Elektronikgehäuse 1 in anreihbarer Bauart, welches hier zum Aufrasten auf eine hutförmige Tragschiene (nicht dargestellt) ausgelegt ist und einen auf die Tragschiene aufrastbaren Montagefuß mit Rastmitteln 2, 3 aufweist. Z.B. an den Rastmitteln 2, 3 kann optional ein Kontakt zur Kontaktierung der Tragschiene angeordnet sein, die in der Regel aus einem leitenden Metall besteht (hier nicht vorgesehen bzw. dargestellt).

Das Elektronikgehäuse 1 weist eine zur Tragschiene hin liegende Grundwand 4 auf, vier Seitenwände 5, 6, 7, 8 und eine obere Abdeckung 9 (siehe Fig. 2).

Zwei der Seitenwände 5, 6 liegen parallel zueinander und bilden die seitlichen Abdeckungen in Anreihrichtung X des Elektronikgehäuses. Sie werden nachfolgend als die Hauptseitenwände 5, 6 bezeichnet.

Hier sind die Grundwand 4 sowie die eine der Hauptseitenwände 6 und die Abdeckung 9 einstückig miteinander ausgebildet (siehe Fig. 2).

Zudem ist hier jeweils ein zur Tragschiene hin liegender Basisbereich 10 der zwei weiteren Seitenwände, welche die Seitenwände 5, 6 miteinander verbinden, ebenfalls mit der einen der Hauptseitenwände 6 einstückig ausgebildet.

Die Randbereiche der Hauptseitenwände 5, 6 sind hier gezackt ausgebildet, was vorteilhaft, aber nicht zwingend ist.

Von der einen Hauptseitenwand 6 stehen ferner in Richtung der anderen Hauptseitenwand 6 im Randbereich Rastzapfen 11 vor, die dazu ausgelegt sind, rastend in korrespondierende Rastausnehmungen 12 der anderen Hauptseitenwand 5 einzurasten. Hierdurch wird eine Art Grundgehäuse geschaffen.

Dieses Grundgehäuse ist bis auf Teilbereiche der weiteren Seitenwände 5, 6 - nachfolgend als Schmalseiten bezeichnet - und ggf. bis auf Funktionsöffüngen 13 z.B. für einen Busleiterabschnitt 14 zur Kontaktierung einer in die Tragschiene eingesetzten Busleiste oder zur Lüftung und bis auf seitliche Randaussparungen 15 in der einen Hauptseitenwand 5 - geschlossen ausgebildet. Die Hauptseitenwand 5 mit den Randaussparungen 15 weist damit hier eine geringere Fläche auf als die andere Hauptseitenwand 6.

Im Bereich der Schmalseiten wird jedenfalls ein Teilbereich des Elektronikgehäuses 1 durch Leiteranschlussgehäuse 16 gebildet, welche die Leiteranschlüsse 17 aufnehmen und welche eine Öffnung 27 zum Einstecken der Leiter und ggf. eine Betätigungsöffnung oder ein Betätigungselement zum Öffnen des jeweiligen Leiteranschlusses 17 aufweisen.

Die Leiteranschlüsse 17 können beispielhaft als Druckfederanschlüsse (Push-In) ausgebildet sein. Andere Ausgestaltungen z.B. als Zugfederanschlüsse, als isolationsdurchdringende Kontakte oder als Schraubanschlüsse oder als Kontaktstift oder -buchse wären ebenfalls denkbar.

Hier wird zudem auch ein Randbereich von der einen Hauptseitenwand 5 von den Leiteranschlussgehäusen 16 gebildet.

Das Elektronikgehäuse 1 nimmt die Leiterplatte 18 zwischen den Hauptseitenwänden 5, 6 auf.

Die eine Hauptseitenwand 6 ist hier vorteilhaft derart ausgebildet, dass sie in Anreihrichtung auch die Leiteranschlussgehäuse 16 abdeckt, was nicht zwingend, aber vorteilhaft ist, da sie die Leiteranschlussgehäuse 16 direkt oder über Stützkonturen 27 abstützen kann, um Zug- oder Druckkräfte aufzunehmen. Es ist auch möglich, eine der Seitenwände und/oder die Grundwand oder die Abdeckung 9 mit Rastmitteln wie Haken 29 (hier an der Abdeckung 9) an einer Kontur 30 der Leiteranschlussgehäuse festzulegen.

Die Leiteranschlussgehäuse 16 sind hier derart ausgerichtet, dass die Leiteranschlüsse 17 (Fig. 2) relativ zur Tragschiene schräg von oben her beschaltbar und entschaltbar sind.

Die Leiteranschlussgehäuse 16 bilden dabei in ihrem Zusammenspiel eine gezackte Außenkontur an den Schmalseitenwänden 7, 8 aus.

Die Leiterplatte 18 hat eine flächige, ebene Kontur, die von einem Außenrand 19 begrenzt ist.

Die Leiteranschlussgehäuse 16 der Leiteranschlüsse 17 sind außerhalb des Außenrandes 19 der Leiterplatte 18 angeordnet. Aus den Leiteranschlussgehäusen 16 stehen Kontaktbereiche wie z.B. Kontaktstifte 20 vor, die an oder auf der Leiterplatte 18 verlötet sind. Damit sind die eigentlichen Leiteranschlüsse 17 nicht auf der Leiterplatte sondern außerhalb des Außenrandes 19 seitlich neben der Leiterplatte 18 angeordnet, was den großen Vorteil mit sich bringt, dass sich die Dicke der Leiterplatte 18 und die Dicke der Leiteranschlüsse 17 nicht oder zumindest nicht vollständig addieren, da sich die Leiteranschlussgehäuse 16 bis in die Ebene der Leiterplatte 18 hinein erstrecken.

Die Anordnung aus der Leiterplatte 18 und den Leiteranschlüssen 17 mit den Gehäusen 16 baut damit schmaler, was es ermöglicht, in Anreihrichtung ein besonders schmales Elektronikgehäuse 1 - z.B. in einem 6 mm-Raster - zu realisieren.

Zudem bilden die Leiteranschlussgehäuse 16 der Leiterplatte 18 selbst jedenfalls abschnittsweise an einer oder mehreren Seitenwänden einen Teil des Elektronikgehäuses 1 an sich aus, so dass ein nochmals schmaleres Elektronikgehäuse 1 realisierbar ist.

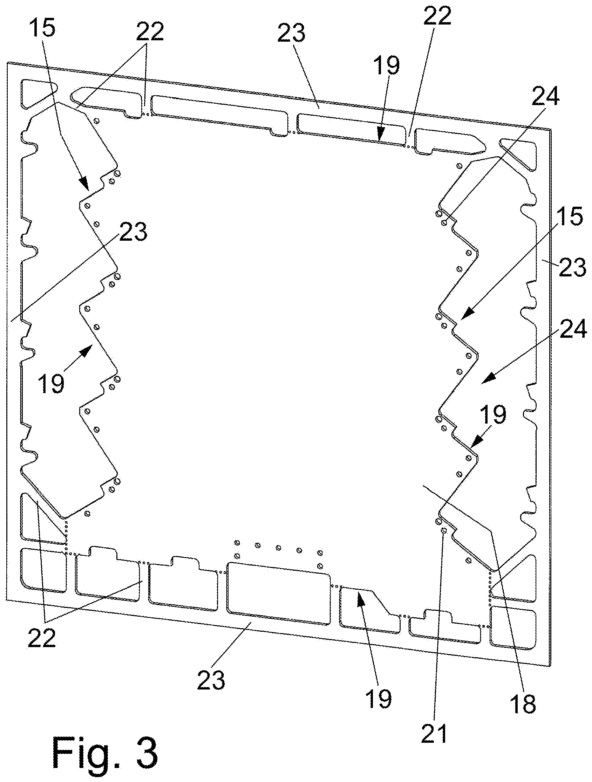

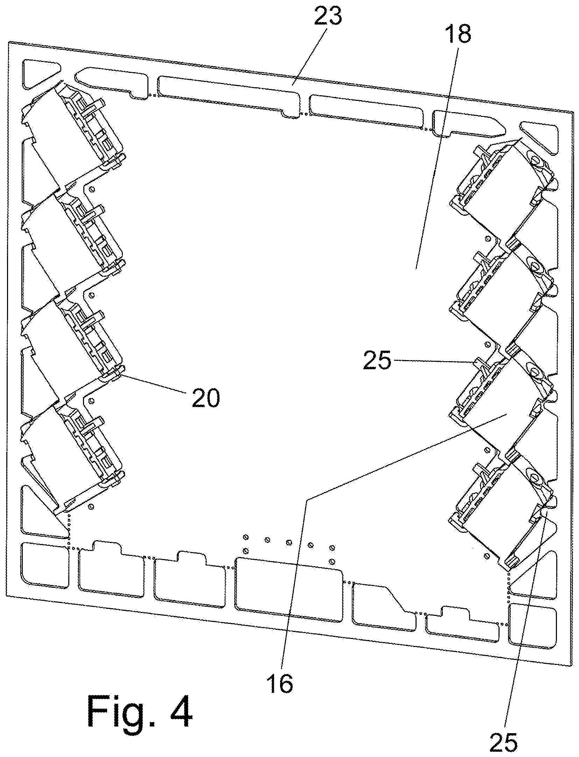

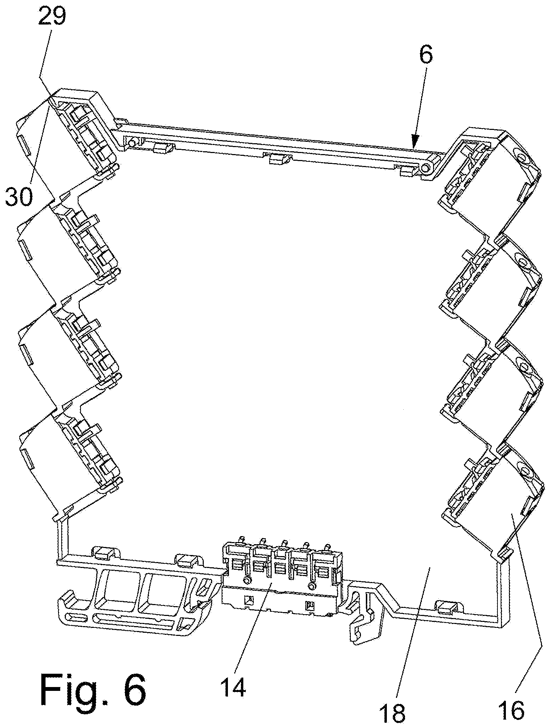

Die Herstellung der Leiterplatte 18 mit den Leiteranschlüssen 17 und den Leiteranschlussgehäusen 16 erschließt sich aus dem Zusammenspiel der Fig. 3 bis 6. Danach wird in einem hier rechteckigen Abschnitt aus Leiterplattenmaterial zunächst die Kontur der Leiterplatte 18 bis einen Umfangsrahmen 23 und bis auf herausbrechbare Materialbrücken 22, welche die Leiterplatte 18 mit dem Umfangsrahmen 23 verbinden, ausgebildet, was beispielsweise mit Hilfe eines Ausfräsens erfolgen kann.

Dabei bilden sich zwischen dem Umfangsrahmen 23 und der Leiterplatte 18 ferner die Randaussparungen 28 aus, in welche die Leiteranschlussgehäuse 16 einlegbar sind, die sich damit bis in die Ebene der Leiterplatte 18 hinein erstrecken. Die Randaussparungen 28 entsprechen hinsichtlich ihrer Kontur den Randaussparungen 15 in der einen Hauptseitenwand. An Stützstegen 25 können sich die Leiteranschlussgehäuse 16 an der Leiterplatte oder am Umfangsrahmen abstützen.

Bei der Montage der vormontierten Leiteranschlussgehäuse mit den Leiteranschlüssen 17 werden vorzugsweise Kontaktbereiche wie z.B. Kontaktstifte 20 in Löchern 24 in der Leiterplatte 18 oder auf Lötflächen auf der Leiterplatte 18 positioniert. Sodann erfolgt ein Verlöten vorzugsweise mittels eines automatisierten Lötverfahrens. Ein Verlöten von Hand ist denkbar. Nach dieser Art sind auch die Busleiterabschnitte 14 an der Leiterplatte 18 anbringbar oder aber andere Funktionselemente. An die Leiteranschlussgehäuse 16 können direkt auch weitere Gehäuseabschnitte des Elektronikgehäuses 1 angeformt sein.

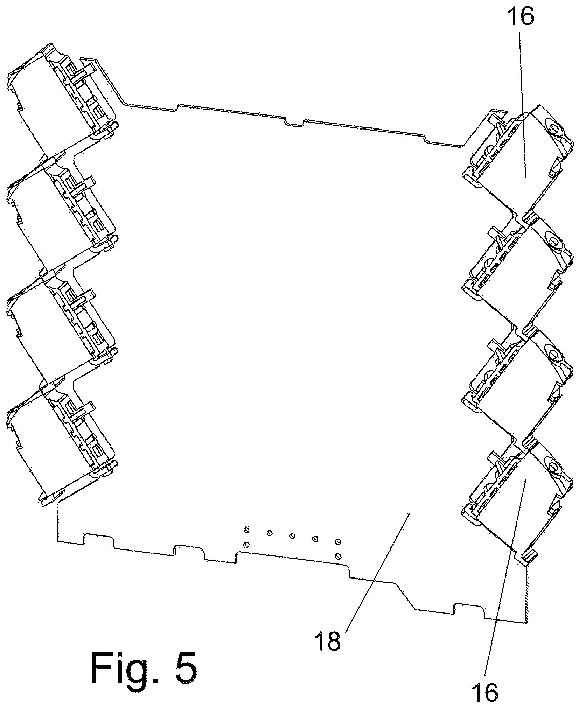

Damit sind die Leiteranschlüsse 17 und damit auch die Leiteranschlussgehäuse 16 an der Leiterplatte 18 fixiert. Sodann können die Materialbrücken 22 weggebrochen werden bzw. die Leiterplatte 18 kann aus dem Rahmen gelöst werden (Fig. 5) und als vormontierte Einheit mit den Leiteranschlussgehäusen 16 hier an die Hauptseitenwand 6 gesetzt werden, wobei dann die Leiteranschlussgehäuse 16 selbst Teilbereiche der Elektronikgehäuse 1 ausbilden. Abschließend wird die andere Hauptseitenwand 5 montiert, was die Montage des Elektronikgehäuses vervollständigt.

Zusätzlich können Stützkonturen 26 an den Seitenwänden 5, 6 die Leiteranschlussgehäuse 17 an den Seitenwänden abstützen und stabilisieren.

Derart ist auf einfache Weise die Montage eines besonders schmal bauenden Elektronikgehäuses 1 mit einer Leiterplatte, vorzugsweise in anreihbarer Ausgestaltung, realisierbar.

### Bezugszeichen

- Elektronikgehäuse: 1
- Rastmittel: 2, 3
- Grundwand: 4
- Seitenwände: 5, 6, 7, 8
- Abdeckung: 9
- Basisbereich: 10
- Rastzapfen: 11
- Rastausnehmungen: 12
- Funktionsöffnungen: 13
- Busleiterabschnitt: 14
- Randaussparungen: 15
- Gehäuse: 16
- Leiteranschlüsse: 17
- Leiterplatte: 18
- Außenrand: 19
- Kontaktstifte: 20
- Ausnehmungen: 21
- Materialbrücken: 22
- Löcher: 24
- Stützstege: 25
- Stützkonturen: 26
- Öffnung: 27
- Randaussparungen: 28
- Haken: 29
- Kontur: 30

## Patentansprüche

1. Anordnung mit einem Elektronikgehäuse (1) in anreihbarer Ausgestaltung zum Aufrasten auf eine Tragschiene und mit einem oder mehreren Leiteranschlüssen (17) für elektrische Leiter und mit einer in dem Elektronikgehäuse (1) aufgenommenen Leiterplatte (18) mit einem Außenrand (19), an welcher die Leiteranschlüsse (17) angeordnet sind, wobei die Leiteranschlüsse (17) in Leiteranschlussgehäusen (16) angeordnet sind, aus denen Kontaktbereiche (20) vorstehen, die an oder auf der Leiterplatte (18) verlötet sind, so dass die Leiteranschlüsse (17) und damit die Leiteranschlussgehäuse (16) an der Leiterplatte (18) fixiert sind, wobei das Elektronikgehäuse (1) zwei zueinander parallel ausgerichtete Hauptseitenwände (5, 6) aufweist, und wobei die Leiteranschlüsse (17) in Leiteranschlussgehäusen (16) außerhalb des Außenrandes (19) der Leiterplatte (18) so neben der Leiterplatte (18) angeordnet sind, dass sich die Dicke der Leiterplatte (18) und der Leiteranschlüsse (17) nicht addieren, **dadurch gekennzeichnet, dass** die Leiteranschlussgehäuse (16) jedenfalls abschnittsweise selbst den Randbereich von einer der Hauptseitenwände (5) des Elektronikgehäuses (1) ausbilden.

2. Anordnung nach Anspruch 1, **dadurch gekennzeichnet, dass** sich die Leiteranschlussgehäuse (16) bis in die Ebene der Leiterplatte (18) hinein erstrecken.

3. Anordnung nach einem der vorstehenden Ansprüche, **dadurch gekennzeichnet, dass** das Elektronikgehäuse (1) weiterhin zwei Schmalseitenwände (7, 8) aufweist und dass die Leiteranschlussgehäuse (16) jedenfalls abschnittsweise selbst einen Teil von wenigstens einer oder der beiden Schmalseitenwände (7, 8) des Elektronikgehäuses (1) ausbilden.

4. Anordnung nach einem der vorstehenden Ansprüche, **dadurch gekennzeichnet, dass** das Elektronikgehäuse (1) ferner eine zur Tragschiene hin liegende Grundwand (4) aufweist und eine obere Abdeckung (9) und dass die Grundwand (4) und/oder die eine der Hauptseitenwände (6) und/oder die Abdeckung (9) einstückig miteinander ausgebildet sind.

5. Anordnung nach einem der vorstehenden Ansprüche, **dadurch gekennzeichnet, dass** jeweils ein zur Tragschiene hin liegender Basisbereich (10) der zwei weiteren Seitenwände, welche die Seitenwände (5, 6) miteinander verbinden, ebenfalls mit der einen Hauptseitenwand (6) einstückig ausgebildet ist.

6. Anordnung nach einem der vorstehenden Ansprüche, **dadurch gekennzeichnet, dass** die eine Hauptseitenwand (5) eine geringere Fläche als die andere Hauptseitenwand (6) aufweist.

7. Anordnung nach Anspruch 6, **dadurch gekennzeichnet, dass** zumindest die eine Hauptseitenwand (5) Randaussparungen (15) aufweist.

8. Anordnung nach einem der vorstehenden Ansprüche, **dadurch gekennzeichnet, dass** die Leiteranschlüsse (17) als Druckfederanschlüsse (Push-In), als Zugfederanschlüsse, als isolationsdurchdringende Kontakte oder als Schraubanschlüsse oder als Kontaktstift oder -buchse ausgebildet sind.

9. Anordnung nach einem der vorstehenden Ansprüche, **dadurch gekennzeichnet, dass** die Leiteranschlussgehäuse (16) sich in die Randaussparungen (15) erstrecken und an einer ihrer Seiten in montierter Stellung mit der Hauptseitenwand (5) mit den Randaussparungen (15) fluchten.

10. Anordnung nach einem der vorstehenden Ansprüche, **dadurch gekennzeichnet, dass** die Leiteranschlussgehäuse (16) in ihrem Zusammenspiel eine gezackte Außenkontur an den Schmalseitenwänden (7, 8) ausbilden.

11. Anordnung nach einem der vorstehenden Ansprüche, **dadurch gekennzeichnet, dass** die der Hauptseitenwand (5) mit den Randaussparungen (15) gegenüberliegende Hauptseitenwand (6) derart ausgebildet ist, dass sie in Anreihrichtung auch die Leiteranschlussgehäuse (16) abdeckt.

12. Anordnung nach einem der vorstehenden Ansprüche, **dadurch gekennzeichnet, dass** in der Leiterplatte (18) zu den Randaussparungen (15) korrespondierende Randaussparungen (28) ausgebildet sind.

13. Anordnung nach einem der vorstehenden Ansprüche, **dadurch gekennzeichnet, dass** die Leiteranschlussgehäuse (16) derart ausgerichtet sind, dass die Leiteranschlüsse (17) relativ zur Tragschiene schräg von oben her beschaltbar und entschaltbar sind.

14. Anordnung nach einem der vorstehenden Ansprüche, **dadurch gekennzeichnet, dass** die Kontaktbereiche als Kontaktstifte (20) ausgebildet sind.

15. Anordnung nach einem der vorstehenden Ansprüche, **dadurch gekennzeichnet, dass** Stützkonturen (26) an den Seitenwänden (5, 6) die Leiteranschlussgehäuse (17) an den Seitenwänden abstützen und stabilsieren.

16. Verfahren zur Herstellung einer Anordnung nach einem der vorstehenden Ansprüche, welche ein Elektronikgehäuse (1) mit zwei Hauptseitenwände (5, 6) und zwei Schmalseitenwände (7, 8) umfasst, **gekennzeichnet durch** folgende Schritte:
a. Anordnen von Leiteranschlussgehäusen, die Leiteranschlüsse (17) aufnehmen, seitlich des Außenrandes (19) der Leiterplatte, und verlöten der Leiteranschlüsse über Kontaktbereiche wie Kontaktstifte an der Leiterplatte,
b. Ausbilden eines Teils wenigstens einer Hauptseitenwand (5) des Elektronikgehäuses (1) **durch** Anordnen der Leiterplatte (17) mit den an ihr angeordneten Leiteranschlussgehäusen (16) in dem Elektronikgehäuse (1).

17. Verfahren nach Anspruch 16, **dadurch gekennzeichnet, dass** in einem Abschnitt aus Leiterplattenmaterial zunächst die Kontur der Leiterplatte (18) bis auf einen Umfangsrahmen (23) und bis auf herausbrechbare Materialbrücken (22), welche die Leiterplatte (18) mit dem Umfangsrahmen (23) verbinden, ausgebildet wird, wobei vorzugsweise ferner Randaussparungen (28) in der Leiterplatte (18) ausgebildet werden.

18. Verfahren nach Anspruch 17, **dadurch gekennzeichnet, dass** in die Zwischenräume zwischen der Leiterplatte (18) und dem Umfangsrahmen (23), insbesondere in die Randaussparungen (28), die Leiteranschlussgehäuse (16) eingelegt werden, so dass sie sich bis in die Ebene der Leiterplatte (18) hinein erstrecken.

19. Verfahren nach Anspruch 18, **dadurch gekennzeichnet, dass** Kontaktbereiche wie z.B. Kontaktstifte (20) der Leiteranschlüsse (20) in Löchern (24) in der Leiterplatte (18) oder auf Lötflächen auf der Leiterplatte (18) positioniert werden und dass ein Verlöten vorzugsweise mittels eines automatisierten Lötverfahrens erfolgt.

20. Verfahren nach Anspruch 19, **dadurch gekennzeichnet, dass** die Materialbrücken (22) weggebrochen werden und die Leiterplatte (18) aus dem Rahmen gelöst und als vormontierte Einheit an die eine Hauptseitenwand (6) gesetzt wird.

21. Verfahren nach Anspruch 20, **dadurch gekennzeichnet, dass** die andere Hauptseitenwand (5) montiert wird.

## Claims

1. An arrangement, comprising an electronic housing (1) in a configuration that can be arranged in a row for latching onto a support rail, and one or several conductor connections (17) for electrical conductors and a printed circuit board (18) which is accommodated in the electronic housing (1) and comprises an outer edge (19) on which the conductor connections (17) are arranged, wherein the conductor connections (17) are arranged in conductor connection housings (16) from which contact regions (20) protrude which are soldered to or onto the printed circuit board (18) so that the conductor connections (17) and thus the conductor connection housings (16) are fixed to the printed circuit board (18), wherein the electronic housing (1) comprises two main side walls (5, 6) which are oriented in parallel with respect to each other, and wherein the conductor connections (17) in the conductor connection housings (16) are arranged outside of the outer edge (19) of the printed circuit board (18) adjacent to the printed circuit board (18) in such a way that the thickness of the printed circuit board (18) and the conductor connections (17) do not add up, **characterized in that** the conductor connection housings (16) themselves form the boundary region of one of the main side walls (5) of the electronic housing (5) at least in sections.

2. An arrangement according to claim 1, **characterized in that** the conductor connection housings (16) extend as far as into the plane of the printed circuit board (18).

3. An arrangement according to one of the preceding claims, **characterized in that** the electronic housing (1) further comprises at least two narrow side walls (7, 8), and the conductor connection housings (16) themselves form a part of at least one or both narrow side walls (7, 8) of the electronic housing (1) at least in sections.

4. An arrangement according to one of the preceding claims, **characterized in that** the electronic housing (1) further comprises a base wall (4), which is disposed toward the support rail, and an upper cover (19), and the base wall (4) and/or the one of the main side walls (6) and/or the cover (9) are integrally formed with respect to each other.

5. An arrangement according to one of the preceding claims, **characterized in that** a base region (10), which is disposed toward the support rail, of the two further side walls which connect the side walls (5, 6) to each other is also integrally formed with the one main side wall (6).

6. An arrangement according to one of the preceding claims, **characterized in that** the one main side wall (5) has a smaller surface area than the other main side wall (6).

7. An arrangement according to claim 6, **characterized in that** at least the one main side wall (5) comprises edge recesses (15).

8. An arrangement according to one of the preceding claims, **characterized in that** the conductor connections (17) are formed as compression-spring connections (push-in), tension-spring connections, insulation-penetrating contacts or screw connections, or as a contact pin or contact jack.

9. An arrangement according to one of the preceding claims, **characterized in that** the conductor connection housings (16) extend into the edge recesses (15) and on one of their sides are in alignment in the mounted position with the main side wall (5) with the edge recesses (15).

10. An arrangement according to one of the preceding claims, **characterized in that** the conductor connection housings (16), in their interaction, form a jagged outer contour on the narrow side walls (7, 8).

11. An arrangement according to one of the preceding claims, **characterized in that** the main side wall (6) opposite the main side wall (5) with the edge recesses (15) is formed in such a way that in the direction of the arrangement in rows it also covers the conductor connection housing (16).

12. An arrangement according to one of the preceding claims, **characterized in that** edge recesses (28) which correspond to the edge recesses (15) are formed in the printed circuit board (18).

13. An arrangement according to one of the preceding claims, **characterized in that** the conductor connection housings (16) are oriented in such a way that the conductor connections (17) can be wired and unwired relative to the support rail obliquely from above.

14. An arrangement according to one of the preceding claims, **characterized in that** the contact regions are formed as contact pins (20).

15. An arrangement according to one of the preceding claims, **characterized in that** support contours (26) on the side walls (5, 6) support and stabilise the conductor connection housings (17) on the side walls.

16. A method for producing an arrangement according to one of the preceding claims, which comprises an electronic housing (1) with two main side walls (5, 6) and two narrow side walls (7, 8), **characterized by** the following steps:
a) arranging conductor connection housings which accommodate conductor connections (17) to the side of the outer edge (19) of the printed circuit board, and soldering of the conductor connections via contact regions such as contact pins onto the printed circuit board;
b) forming a portion of at least one main side wall (5) of the electronic housing (1) by arranging the printed circuit board (17) with the conductor connection housings (16) arranged thereon in the electronic housing (1).

17. A method according to claim 16, **characterized in that** in a section made from printed circuit board material the contour of the printed circuit board (18) is formed at first apart from a circumferential frame (23) and apart from material bridges (22) which can be broken out and which connect the printed circuit board (18) to the circumferential frame (23), wherein preferably further edge recesses (20) are formed in the printed circuit board (18).

18. A method according to claim 17, **characterized in that** the conductor connection housings (16) are placed in the intermediate spaces between the printed circuit board (18) and the circumferential frame (23), especially in the edge recesses (20), so that they extend as far as into the plane of the printed circuit board (18).

19. A method according to claim 18, **characterized in that** contact regions such as contact pins (20) of the conductor connections (20) are positioned in the holes (24) in the printed circuit board (18) or solder surfaces on the printed circuit board (18), and soldering preferably occurs by means of an automated soldering method.

20. A method according to claim 19, **characterized in that** the material bridges (22) are broken away, and the printed circuit board (18) is detached from the frame and is placed as a premounted unit on the one main side wall (6).

21. A method according to claim 20, **characterized in that** the other main side wall (5) is mounted.

## Revendications

1. Disposition avec un boîtier électronique (1) conçu pour pouvoir être monté en rangée et emboîté sur un rail de support et avec une ou plusieurs connexions de conducteurs (17) pour des conducteurs électriques et avec une carte de circuits (18) logée dans le boîtier électronique (1) et comportant un bord extérieur (19) sur lequel sont disposées les connexions de conducteurs (17), les connexions de conducteurs (17) étant disposées dans des boîtiers de connexion de conducteurs (16) desquels dépassent des zones de contact (20) qui sont brasées sur la carte de circuits (18) de telle manière que les connexions de conducteurs (17) et, de ce fait, les boîtiers de connexion de conducteurs (16) soient fixés sur la carte de circuits (18), le boîtier électronique (1) comportant deux parois latérales principales (5, 6) orientées parallèlement l'une à l'autre et les connexions de conducteurs (17) étant disposées dans des boîtiers de connexion de conducteurs (16) à côté de la carte de circuits (18), en dehors du bord extérieur (19) de la carte de circuits (18), de telle façon que les épaisseurs de la carte de circuits (18) et des connexions de conducteurs (17) ne s'additionnent pas, **caractérisée en ce que** les boîtiers de connexion de conducteurs (16) forment dans tous les cas eux-mêmes, par sections, la zone de bord de l'une des parois latérales principales (5) du boîtier électronique (1).

2. Disposition selon la revendication 1, **caractérisée en ce que** les boîtiers de connexion de conducteurs (16) s'étendent jusque dans le plan de la carte de circuits (18).

3. Disposition selon l'une des revendications précédentes, **caractérisée en ce que** le boîtier électronique (1) comporte en outre deux parois de petits côtés (7, 8) et **en ce que** les boîtiers de connexion de conducteurs (16) forment dans tous les cas eux-mêmes, par sections, une partie d'au moins une des parois de petits côtés (7, 8) du boîtier électronique (1) ou des deux.

4. Disposition selon l'une des revendications précédentes, **caractérisée en ce que** le boîtier électronique (1) présente en outre une paroi de fond (4) tournée vers le rail de support et une couverture (9) sur le dessus et **en ce que** la paroi de fond (4) et/ou une des parois latérales principales (6) et/ou la couverture (9) sont formées ensemble d'un seul tenant.

5. Disposition selon l'une des revendications précédentes, **caractérisée en ce qu'**une zone de base (10) des deux autres parois latérales reliant les parois latérales (5, 6) entre elles tournée vers le rail de support est également formée d'un seul tenant avec une paroi latérale principale (6).

6. Disposition selon l'une des revendications précédentes, **caractérisée en ce qu'**une paroi latérale principale (5) a une plus petite aire que l'autre paroi latérale principale (6).

7. Disposition selon la revendication 6, **caractérisée en ce qu'**au moins une paroi latérale principale (5) présente des découpes dans le bord (15).

8. Disposition selon l'une des revendications précédentes, **caractérisée en ce que** les connexions de conducteurs (17) sont conçues comme des connexions à ressort de compression (*push-in*), comme des connexions à ressort de traction, comme des contacts traversant l'isolation ou comme des connexions vissées ou comme une fiche ou une prise de contact.

9. Disposition selon l'une des revendications précédentes, **caractérisée en ce que** les boîtiers de connexion de conducteurs (16) s'étendent dans les découpes dans le bord (15) et l'un de leurs côtés est aligné avec les découpes dans le bord (15) dans la position assemblée avec la paroi latérale principale (5).

10. Disposition selon l'une des revendications précédentes, **caractérisée en ce que** l'interaction des boîtiers de connexion de conducteurs (16) forme un contour extérieur en dents de scie sur les parois de petits côtés (7, 8).

11. Disposition selon l'une des revendications précédentes, **caractérisée en ce que** la paroi latérale principale (6) faisant face à la paroi latérale principale (5) avec les découpes dans le bord (15) est conformée de telle façon qu'elle recouvre aussi les boîtiers de connexion de conducteurs (16) dans le sens d'alignement.

12. Disposition selon l'une des revendications précédentes, **caractérisée en ce que** des découpes dans le bord (28) correspondant aux découpes dans le bord (15) sont formées dans la carte de circuits (18).

13. Disposition selon l'une des revendications précédentes, **caractérisée en ce que** les boîtiers de connexion de conducteurs (16) sont orientés de telle manière que les connexions de conducteurs (17) puissent être brochées et débrochées en oblique par le haut par rapport au rail de support.

14. Disposition selon l'une des revendications précédentes, **caractérisée en ce que** la zones de contact est conformée comme des broches de contact (20).

15. Disposition selon l'une des revendications précédentes, **caractérisée en ce que** des contours d'appui (26) sur les parois latérales (5, 6) soutiennent et stabilisent les boîtiers de connexion de conducteurs (17) sur les parois latérales.

16. Procédé pour fabriquer un dispositif selon l'une des revendications précédentes comprenant un boîtier électronique (1) avec deux parois latérales principales (5, 6) et deux parois de petits côtés (7, 8), **caractérisé en ce qu'**il comprend les étapes suivantes :
a. disposition de boîtiers de connexion de conducteurs recevant les connexions de conducteurs (17) sur le côté du bord extérieur (19) de la carte de circuits et brasage des connexions de conducteurs par-dessus des zones de contact telles que des broches de contact sur la carte de circuits ;
b. formation d'au moins une partie d'une paroi latérale principale (5) du boîtier électronique (1) par la disposition de la carte de circuits (17) avec les boîtiers de connexion de conducteurs (16) disposés dessus dans le boîtier électronique (1).

17. Procédé selon la revendication 16, **caractérisé en ce que** le contour de la carte de circuits (18) est d'abord formé dans une section du matériau de la carte de circuits, sauf un cadre d'entourage (23) et sauf des ponts de matériau (22) pouvant être cassés et reliant la carte de circuits (18) au cadre d'entourage (23), des découpes dans le bord (28) étant en outre formées, de préférence, dans la carte de circuits (18).

18. Procédé selon la revendication 17, **caractérisé en ce que** les boîtiers de connexion de conducteurs (16) sont insérés dans les espaces entre la carte de circuits (18) et le cadre d'entourage (23), en particulier dans les découpes dans le bord (28), de sorte qu'ils s'étendent jusque dans le plan de la carte de circuits (18).

19. Procédé selon la revendication 18, **caractérisée en ce que** des zones de contact des connexions de conducteurs (20), par exemple des broches de contact (20), sont disposées dans des trous (24) dans la carte de circuits (18) ou sur des surfaces de brasage sur la carte de circuits (18) et **en ce qu'**un brasage est réalisé, de préférence au moyen d'un procédé de brasage automatisé.

20. Procédé selon la revendication 19, **caractérisée en ce que** les ponts de matériau (22) sont cassés et la carte de circuits (18) est détachée du cadre et posée sous la forme d'une unité préassemblée sur une paroi latérale principale (6).

21. Procédé selon la revendication 20, **caractérisée en ce que** l'autre paroi latérale principale (5) est assemblée.
